# EUROPEAN PATENT SPECIFICATION

(11) **EP 0 399 261 B1**
(45) Date of publication and mention of the grant of the patent: **15.03.1995**
(21) Application number: 90108427.7
(22) Date of filing: 04.05.1990
(51) Int. Cl.: H01L 29/788, H01L 29/10, G11C 17/00

(54) **Band-to-band induced substrate hot electron injection**
Band/Band induzierte Injektion heisser Elektronen aus dem Substrat
Injection d'électrons chauds du substrat induite par un transfert de bande à bande

(30) Priority: 24.05.1989 US 356809
(43) Date of publication of application: 28.11.1990
(73) Proprietor: TEXAS INSTRUMENTS INCORPORATED, Dallas Texas 75265 (US)
(72) Inventor: Chen, Ih-Chin, Richardson Texas 75082 (US)
(74) Representative: Leiser, Gottfried, Dipl.-Ing.

(56) References cited:
- EP-A- 0 040 251
- US-A- 4 577 295
- US-A- 4 821 236
- IEEE JOURNAL OF SOLID-STATE CIRCUITS. vol. sc-19, no. 1, February 1984, NEWYORK US pages 135 - 143; J.L MC CREARY et al.: "Techniques for a 5-V-only 64KEPROM based upon substrate hot-electron injection"
- IEEE ELECTRON DEVICE LETTERS. vol. 10, no. 7, July 1989, NEW YORK US pages 297- 300; IH-CHIN CHEN et al.: "Gate current injection initiated by electron band-to-band tunneling in MOS devices"

## Description

### FIELD OF THE INVENTION

The present invention relates to the field of integrated circuit technology. More specifically, the present invention relates to a method of transporting charged particles across an insulator with particular application to non-volatile memories.

### BACKGROUND OF THE INVENTION

Present non-volatile memory devices use channel hot electron or tunneling techniques to provide a stored charge on a floating gate to indicate a stored data bit. The most commonly used insulator to surround the floating gate is silicon dioxide. When stressed, electrons tunnel through the silicon dioxide insulator barrier using Fowler-Nordheim tunneling. See Lenzlinger and Snow, "Fowler-Nordheim tunneling into thermally grown SiO₂", Journal of Applied Physics, Vol. 40, No. 1, January 1969, pages 278-283. Another method used is channel hot electron injection. In channel hot electron injection, high velocity current is established between the source and drain. This high velocity current in turn induces impact ionization to provide free electrons having high energy. A certain percentage of these free electrons are drawn by bias on the floating gate to cross the silicon dioxide barrier. A limitation of Fowler-Nordheim tunneling is the high field required across the insulator. This high field coupled with tunneling eventually destroys the integrity of the insulator layer and causes shorting between the floating gate and the substrate. Therefore, it is desirable to provide an electron injection mechanism operating at a lower electric field across the insulator between the substrate and the floating gate.

On the other hand, the injection efficiency of channel hot electron injection is typically below 10⁻⁶. Owing to this low efficiency, a high drain current has to be applied to the device being programmed. This high current usually exceeds the capability of on-chip current capacity and thus requires an external power supply to provide the current, which is considered a major inconvenience. It is thus desirable to have an injection mechanism with high injection efficiency.

In EP-A-0 040 251 a memory device is described which includes a substrate comprising a semiconductive material of a first conductivity type. In said substrate a drain region is formed having a conductivity type opposite to said substrate. A first insulating layer is formed on the surface of said substrate laterally adjacent to said drain region. A conductor is formed of said insulating layer. The device further comprises a doped region of the same conductivity type as said substrate. The doping concentration of said doped region is at least one order of magnitude greater than the doping concentration of said substrate.

### SUMMARY OF THE INVENTION

The described embodiments of the present invention relate to a method for using band-to-band tunneling induced substrate hot electron injection. In the described embodiment, the channel region of a floating gate transistor is doped to a heavily P typed doping region which is the same doping type as the substrate. The gate is brought up to the voltage sufficient to cause a heavily doped channel to invert. A positive voltage is applied to the source and drains of the transistor thus causing the inverted electrons at the interface between the gate insulator and the substrate to be drawn away. This creates a deep depletion region, which causes band-to-band tunneling. With the removal of the inverted electrons, the band-to-band induced holes are driven away by the positive charge on the gate. These holes generate further electron hole pairs by impact ionization. A certain proportion of the electrons will have energy sufficient to overcome the energy barrier provided by the insulator between the gate and the substrate. This energy coupled with the field on the gate causes electron flow from the substrate into the gate.

Two important features of the present invention are the reduced field provided across the gate insulator for a given substrate to gate current and the high injection efficiency. Because this field is minimized, relative to Fowler-Nordheim tunneling and channel hot electron injection, gate insulator lifetime is maximized.

### DESCRIPTION OF THE DRAWING

The present invention is best understood with the following detailed description of the preferred embodiments in conjunction with the drawings, wherein:
Figure 1 is a band diagram of the gate to substrate interface when Fowler-Nordheim tunneling is induced;
Figure 2 is a band diagram of the gate to substrate illustrating band-to-band tunneling induced hot electron injection;
Figure 3 is a side view schematic diagram of an experimental apparatus to determine the characteristics of band-to-band induced substrate hot electron injection;
Figure 4 is a graph depicting Fowler-Nordheim tunneling induced in the structure of Figure 3;
Figure 5 is a graph depicting band-to-band induced substrate hot electron injection in the structure of Figure 3;
Figure 6 is a side view schematic diagram of the structure of Figure 3 showing the depletion region induced by the voltage provided on source/drains 14;
Figure 7 is a graph showing the band-to-band induced current versus the drain voltage;
Figure 8 is a side view schematic diagram of another experimental device used to determine the electrical characteristics of band-to-band induced substrate hot electron injection;
Figure 9 is a graph showing the tunneling of the structure of Figure 8 both using band-to-band induced substrate hot electron injection and Fowler-Nordheim tunneling;
Figure 10 is a graph taken flom Figure 9 of Chan, et al. (cited below) indicating the optimal doping density for band-to-band tunneling;
Figure 11 is a graph showing the difference in band-to-band induced substrate hot electron injection for different doping levels showing the gate voltage versus the drain and gate currents;
Figure 12 is a graph depicting the gate current versus drain current ratio versus gate voltage and the calculated substrate surface potential for the doping levels of the P+ region of the structure of Figure 3 showing the higher surface potential and greater gate current to drain current density for the 8 × 10¹⁷ atoms per cubic centimeter concentration; and
Figure 13 is a side view schematic diagram of a device incorporating band-to-band tunneling induced substrate hot electron injection which functions as an EPROM.

### DETAILED DESCRIPTION

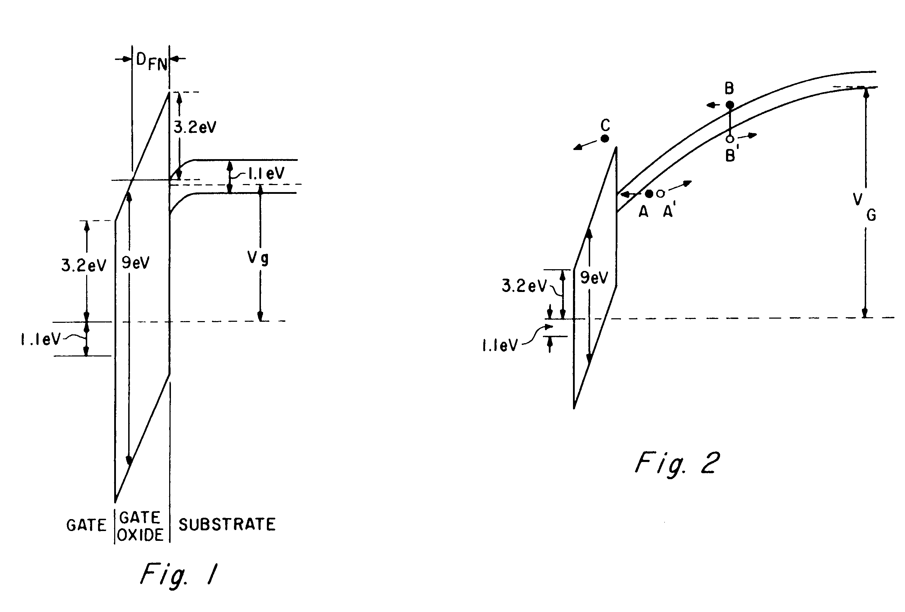

The described embodiments of the present invention employ a new mechanism for injecting electrons from the substrate of an integrated circuit into a floating gate. This process is called band-to-band induced substrate on electron injection (hereinafter "band-to-band injection"). In traditional Fowler-Nordheim tunneling injection, a positive voltage V_{*g*} applied to the gate causes band bending as shown in Figure 1. When the thickness between the conduction band of the substrate and the conduction band of the gate oxide is a distance D_{*FN*}, Fowler-Nordheim tunneling occurs. See Lenzlinger and Snow above.

In the present invention, the inverted electrons which accumulate at the interface between the gate oxide and the substrate are drawn away by a positive voltage applied to the source and drain of the floating gate cell. This eliminates the inversion potential and removes the electrons from the inverted region at the interface between the gate oxide and the substrate. This forces the substrate into deep depletion. In deep depletion, band-to-band tunneling occurs where electron A band-to-band tunnels from the valence band to the conduction band. Electron A is then swept away through the source or drain which is tied to a positive voltage. The remaining hole A′ is driven from the gate by the positive potential applied to the gate. This high voltage causes impact ionization which creates further electron hole pair B and B′. Electron B, because of the potential applied to the gate and the strong band bending, has an energy greater than the energy required to reach the conduction band of the gate oxide. Electrons having this energy level of the mean distance of diffusion of approximately 10 nm (100 Angstroms). Thus, a certain number of these electrons will cross the gate oxide into the floating gate before losing the energy level acquired and falling into the normal valence and conduction bands of the semiconductor substrate.

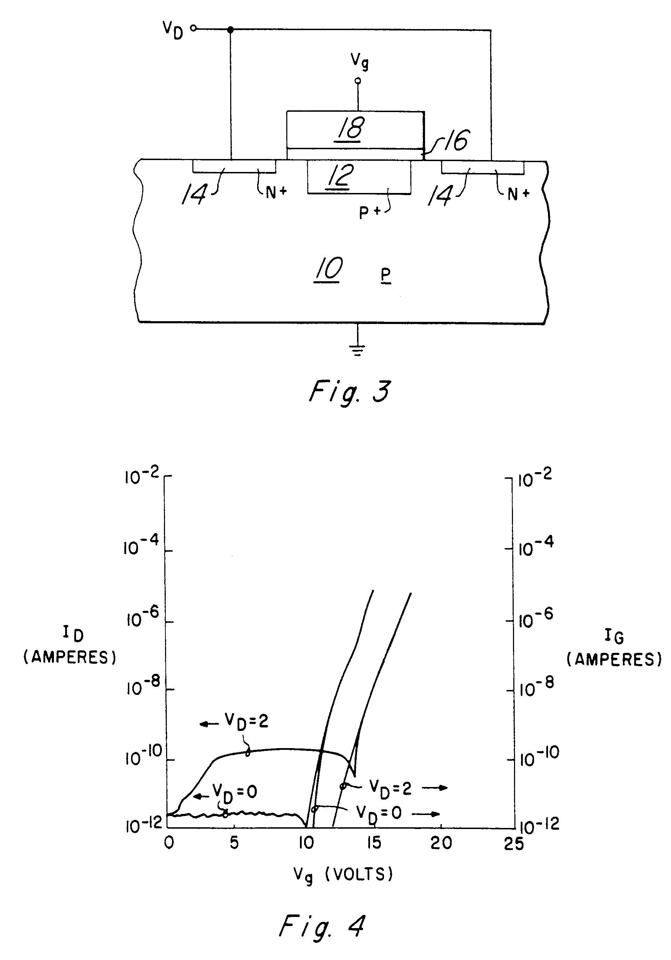

Figure 3 is a side view schematic diagram of an experimental structure used to verify the band-to-band tunneling phenomenon. Substrate 10 is doped P type and connected to ground. P+ region 12 is formed in substrate 10 and is doped to doping level approximately 8 × 10¹⁷ atoms per cubic centimeter. The doping level of P+ region 12 is at least an order of magnitude greater than that of substrate 10. N+ source and drains 14 are fabricated by ion implantation of heavy arsenic ions with a dosage of approximately 5 × 10¹⁵ ions per centimeter squared and an energy of approximately 150 kiloelectron volts. Gate oxide layer 16 is formed by thermal oxidation of substrate 10 to a thickness of approximately 15.6 nm (156 Angstroms) using well known techniques. Gate 18 is formed by deposition of polycrystalline silicon on the surface of gate oxide 16 and patterning the stack of gate oxide layer 16 and polycrystalline silicon layer 18. The gate is tied to voltage V_{*g*} and the source and drain are tied to voltage V_{*d*}.

Figure 4 is a graph showing the drain current and gate currents versus the voltage applied to the gate V_{*g*}. This measurement was taken with V_{*d*} = 0 Volts and V_{*d*} = 2 Volts. These curves show the classic Fowler-Nordheim relationship whereby when the appropriate threshold voltage, approximately 10 volts for 156 Angstrom gate oxide beyond the above described doping levels. With a drain voltage at 0 volts, a drain current showing noise leakage occurs up until gate voltage of approximately 10 volts. Then, the Fowler-Nordheim tunneling begins to occur and a drain current from the drains to the gates begins to rise. A similar pattern is shown for the drain voltage equal to 2 volts excepting a larger drain leakage occurs before Fowler-Nordheim tunneling begins, and a 2 Volt shift is required to apply the appropriate 10 Volt gate oxide voltage level to induce Fowler-Nordheim tunneling.

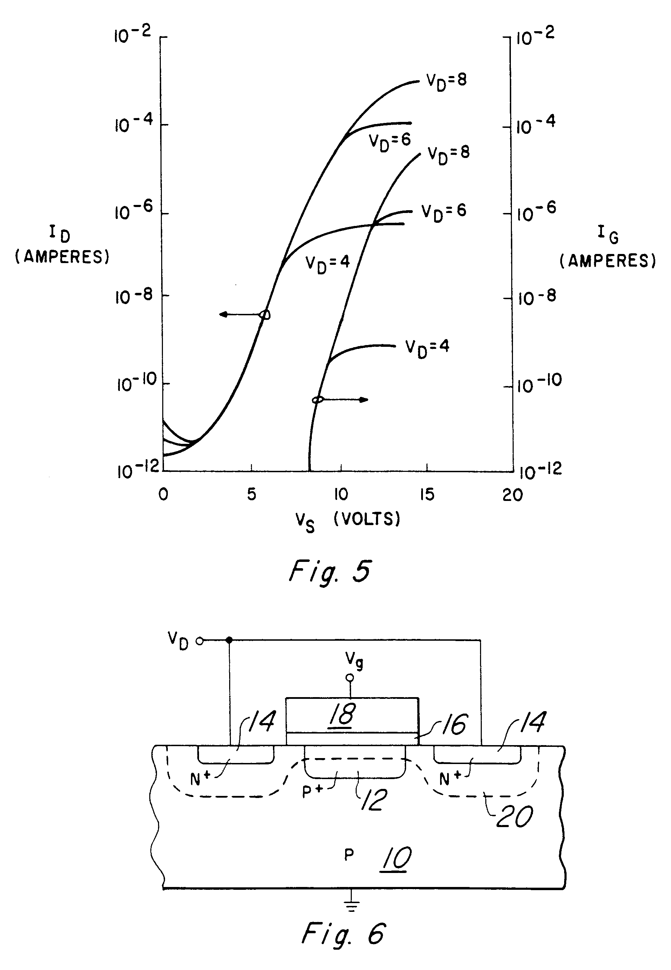

Figure 5 is a side view schematic diagram of the gate voltage of Figure 3 versus the drain current and the gate current. These curves were taken with drain voltages of between 4 and 8 Volts. These curves show the characteristics of band-to-band induced substrate hot electron injection. For example, with V_{d} = 4 Volts, below approximately 8 Volts, leakage current occurs until a gate voltage of approximately 8 Volts is reached and a gate current begins to Bow. With a gate voltage of approximately 8 Volts and a drain voltage of approximately 4 Volts, the voltage drop across the gate oxide is approximately 4 Volts, which is well below the threshold required for Fowler-Nordheim tunneling. Given the dependence of the drain current on the gate voltage and the limiting effect of the gate voltage, it is indicated that band-to-band tunneling is a source of the leakage flom the drain to the substrate and the source of the electrons causing the gate current. The experiment done on this device indicated that a gate current approximately two orders of magnitude lower than the drain current is provided. Similar characteristics were found with drain voltages of 6 and 8 volts. Note that the voltage differences between the gate voltage and the drain voltage thus indicating the voltage drop across the gate oxide is far less than that required for Fowler-Nordheim Tunneling.

Figure 6 is a side view schematic diagram of the structure of Figure 3 including depletion barrier line 20, as shown in Figure 6. When sufficient voltage is supplied to drains 14 and gate 18, depletion region 20 occurs as shown. Because the positive voltage applied to the drain draws electrons away flom the surface interface between P+ region 13 and gate oxide 16, deep depletion but not inversion occurs at this interface.

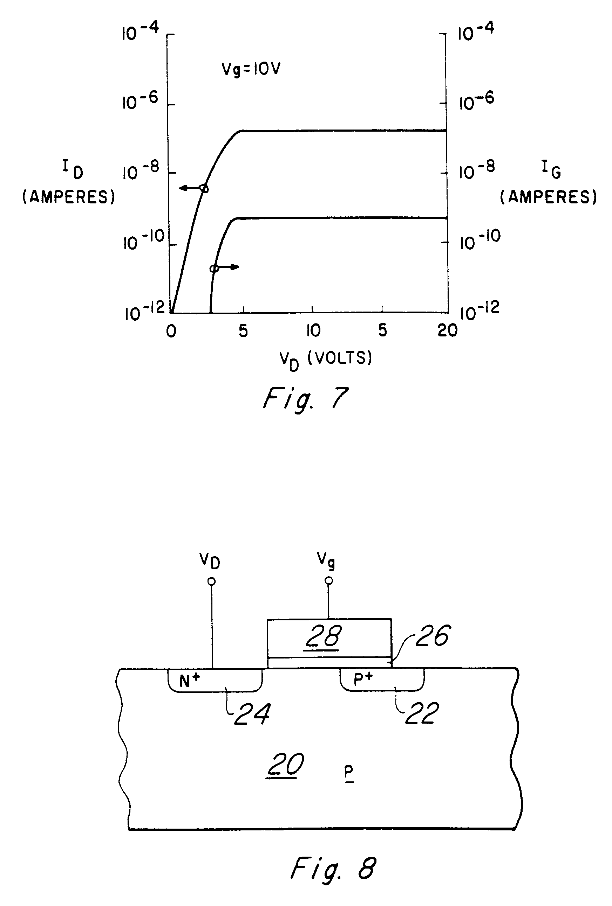

Figure 7 is a graph depicting the drain current and gate current versus the drain voltage for a constant gate voltage of 10 Volts. Figure 7 shows that the band-to-band tuuneling is easily controlled by the drain voltage and provides a well behaved gate current on the order of 10⁻⁹ Amperes after the threshold voltage of approximately 5 volts is reached.

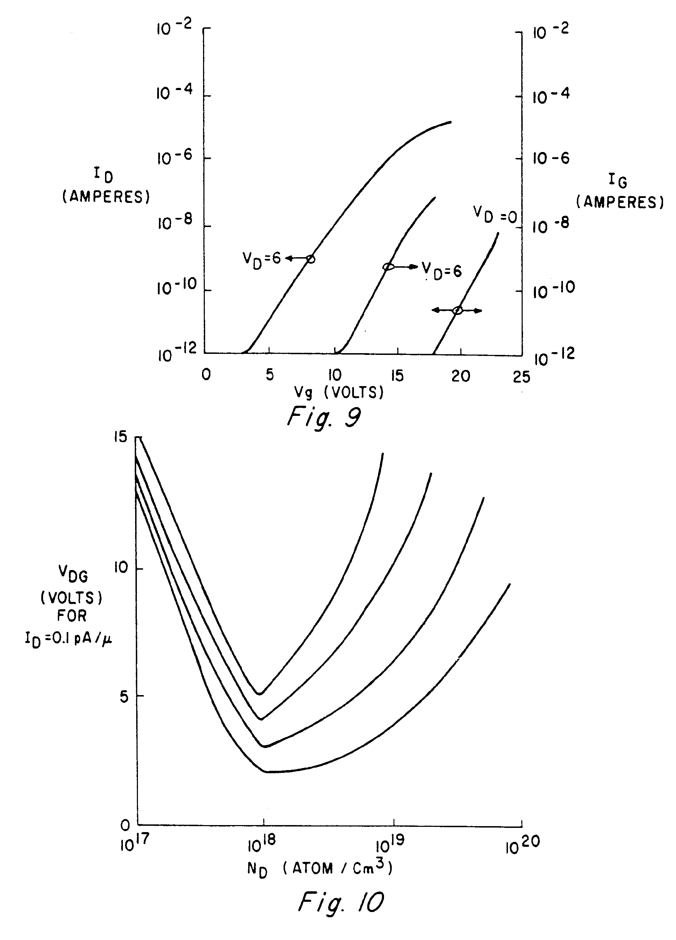

Figure 8 is a side view schematic diagram of a second experimental structure showing the band-to-band induced substrate hot electron injection effect. An experiment was conducted using a drain voltage of 6 volts and a drain voltage of 0 Volts. The results are charted on Figure 9, graphing the gate voltage versus the drain voltage and gate current. At 6 Volts, it is clear that band-to-band injection is occurring. At 0 Volts, it appears that Fowler-Nordheim tunneling is occurring because of the identical drain and gate currents. With the drain voltage at 6 Volts it appears that current begins to Bow into the gate at approximately 11 Volts. Note that this is much less than the 18 Volts that the V_{*d*} = 0 curve would indicate is required across the gate oxide for Fowler-Nordheim tunneling.

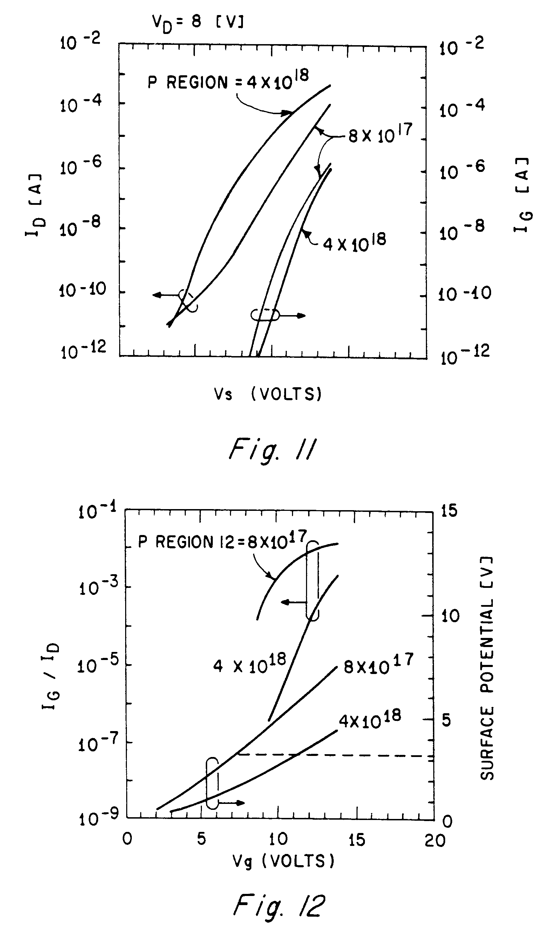

Figure 10 is a graph taken flom Figure 9 of Chan, et al., "The Impact of Gate-Induced Drain Leakage Current on MOSFET Scaling", 1987 International Electron Devices Meeting, pages 718-721. Chan, et al. determined that a gate induced leakage mechanism in small MOSFETs was caused by band-to-band tunneling flom the drains to the substrate. Figure 10 is a plot of the voltage required for a drain leakage of 0.1 Picoamperes per micron versus the concentration of the drain. The work of Chan, et al. suggests that a peak inducement of band-to-band tunneling may be achieved at a doping concentration of approximately 10¹⁸ atoms per cubic centimeter with the optimal doping concentration being in the range of 8 × 10¹⁷ to 2 × 10¹⁸ atoms per cubic centimeter. This is confirmed in the data shown in Figures 11 and 12.

In Figure 11, the structure of Figure 3 is fabricated with P+ region 12 having a doping concentration of 8 × 10¹⁷ atoms per cubic centimeter and a doping concentration of 4 × 10¹⁸ atoms per cubic centimeter. The gate voltage was varied and the drain voltage was held constant at 8 Volts. It was found that a higher drain current was required for a slightly lower gate current for the device having the doping concentration of 4 × 10¹⁸ as opposed to the device having the doping concentration of 8 × 10¹⁷ atoms per cubic centimeter. This data is translated in Figure 12 to a gate over drain current ratio versus gate voltage. Note that a higher gate current is achieved per drain current with a doping concentration of 8 × 10¹⁷ atoms per cubic centimeter as opposed to a doping concentration for P region 12 of 4 × 10¹⁸ atoms per centimeter cubed. An explanation for this phenomenon is indicated by the calculated surface potential numbers for the two doping levels. Because of the higher doping level of the P region 12 using 4 × 10¹⁸, P region 12 has a higher conductivity level and thus a lower surface potential. This lower surface potential induces fewer electrons caused by band-to-band tuuneling induced hot electrons cross the gate oxide barrier thus reducing the gate current.

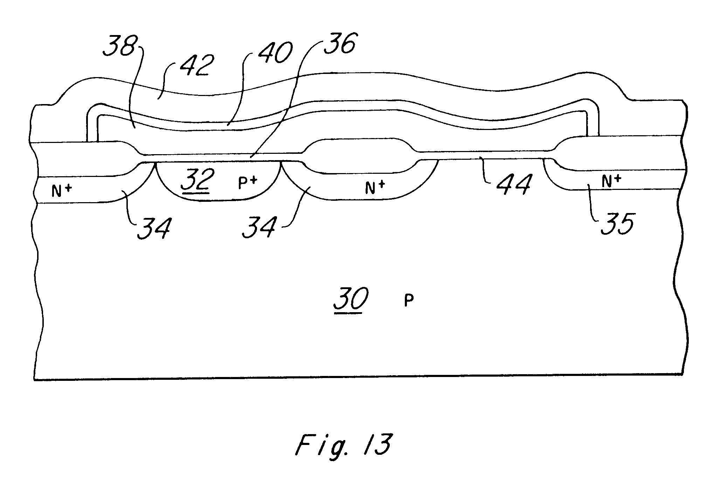

Figure 13 is a side view schematic diagram showing a non-volatile memory cell using band-to-band injection. Hot electron injection is provided by providing a high voltage on control line 42 which capacitively couples a high voltage across interlevel oxide level 40 to floating gate 38. A high voltage is then placed on drain regions 34 and band-to-band tunneling induced substrate hot electron injection occurs flom substrate 30 across gate oxide 36 into floating gate 38. The voltages on drains 34 and control gate 42 are then lowered and data is read by sensing the conductivity of channel 44 in response to a reading voltage of approximately 5 Volts placed on control gate 42. If a charge is placed on floating gate 38, a level of 5 Volts will not turn on channel 44 and an op en is detected between drains 34 and source 35. If floating gate 38 is not charged, channel 44 will conduct and continuity can be detected between drains 34 and source 35. The device is erased by providing ultraviolet light to the surface of the structure of Figure 13 thus causing discharge of floating gate 38 by photon excitation.

Although specific doping types are used in the described experimental structures of the present invention, other doping levels can operate to provide band-to-band induced substrate hot electron injection. For example, reversing the doping types of the structure of Figure 30 and providing negative voltages on floating gate 38 and drains 34 could provide hole injection into gate 38. However, because of the greater barrier between the valence band of silicon dioxide and the valence band of silicon, this hole injection is less efficient and requires voltages which may be damaging to gate oxide 36. Other doping levels and configurations will become readily apparent to those skilled in the art in light of the teachings of this specification.

## Claims

1. A method of transporting charged particles across an insulator (36), comprising the steps of:
holding a semiconductor substrate (30) at a reference potential, where said insulator (36) is formed on the surface of said substrate (30);
providing a field potential on a conductor (38) formed on said insulator (36), where said insulator (36) separates said substrate (30) and said conductor (38), thereby establishing an electric field across said insulator (36) and into said substrate (30), said electric field being large enough to induce band to band tunneling in said substrate (30); and
providing a sink potential on a diffused region (34, 35) in said substrate (30), said diffused region (34, 35) having a conductivity type opposite to the conductivity of said substrate (30), said sink being close enough to said electric field to remove minority carries formed by band to band tunneling at the interface between said substrate (30) and said insulator (36), thereby causing the majority carriers generated by said band to band tunneling to create high energy carriers due to impact ionization, at least a portion of said high energy carriers having enough energy to cross said insulator (36) into said conductor (38).

2. A method as in claim 1, wherein said substrate at said interface is doped to a dopant concentration of approximately 8 x 10¹⁷ to 2 x 10¹⁸ atoms per cubic centimeter.

3. A method as in claim 1 where said substrate (30) comprises crystalline silicon.

4. A method as in claim 1 where said insulator (36) is silicon dioxide.

5. A method as in claim 1 where said field is applied to said conductor (38) through capacitive coupling and said conductor (38) is surrounded by insulating material.

## Patentansprüche

1. Verfahren zum Transportieren geladener Teilchen durch einen Isolator (36), enthaltend die Schritte:
Halten eines Halbleitersubstrats (30) auf einem Referenzpotential, wobei der Isolator (36) auf der Oberfläche des Substrats (30) gebildet ist;
Erzeugen eines Feldpotentials auf einem Leiter (38), der auf dem Isolator (36) gebildet ist, wobei der Isolator (36) das Substrat (30) und den Leiter (38) trennt, wodurch ein elektrisches Feld durch den Isolator (36) hindurch und in das Substrat (30) erzeugt wird, das groß genug ist, um einen Tunnelvorgang von Band zu Band in dem Substrat (30) zu induzieren; und
Erzeugen eines Ableitpotentials auf einer diffundierten Zone (34, 35) in dem Substrat (30), wobei die diffundierte Zone (34, 35) einen Leitungstyp hat, der dem Leitungstyp des Substrats (30) entgegengesetzt ist, wobei das Ableitpotential nahe genug bei dem elektrischen Feld liegt, um Minoritätsträger zu entfernen, die durch den Band-zu-Band-Tunnelvorgang an der Grenzfläche zwischen dem Substrat (30) und dem Isolator (36) erzeugt werden, wodurch die durch den Band-zu-Band-Tunnelvorgang erzeugten Majoritätsträger zu veranlassen, durch Stoßionisation Hochenergieträger zu erzeugen, von denen wenigstens ein Teil eine genügend große Energie haben, um den Isolator (36) in den Leiter (38) hinein zu durchdringen.

2. Verfahren nach Anspruch 1, bei welchem das Substrat an der Grenzfläche bis zu einer Dotierungskonzentration von etwa 8 x 10¹⁷ bis 2 x 10¹⁸ Atome pro Kubikzentimenter dotiert ist.

3. Verfahren nach Anspruch 1, bei welchem das Substrat (30) aus kristallinem Silicium besteht.

4. Verfahren nach Anspruch 1, bei welchem der Isolator (36) Siliciumdioxid ist.

5. Verfahren nach Anspruch 1, bei welchem das an den Leiter (38) durch kapazitive Kopplung angelegt ist und der Leiter (38) von isolierendem Material umgeben ist.

## Revendications

1. Procédé pour transporter des particules chargées à travers un isolant (36), comportant les étapes consistant à :
maintenir un substrat semiconducteur (30) à un potentiel de référence, ledit isolant (36) étant formé sur la surface dudit substrat (30) ;
fournir un potentiel de champ sur un conducteur (38) formé sur ledit isolant (36), ledit isolant (36) séparant ledit substrat (30) et ledit conducteur (38), de manière à établir un champ électrique à travers ledit isolant (36) et dans ledit substrat (30), ledit champ électrique étant suffisamment grand pour induire une circulation bande à bande par effet tunnel dans ledit substrat (30) ; et
fournir un puits de potentiel sur une région diffusée (34,35) dans ledit substrat (30), ladite région diffusée (34,35) ayant un type de conductivité opposé à la conductivité dudit substrat (30), ledit puits étant suffisamment proche dudit champ électrique pour supprimer des porteurs minoritaires formés à l'interface entre ledit substrat (30) et ledit isolant (36) par circulation bande à bande par effet tunnel provoquant ainsi la création de porteurs à haute énergie par les porteurs majoritaires engendrés par ladite circulation bande à bande par effet tunnel, due à une ionisation par impact, au moins une partie desdits porteurs à haute énergie ayant une énergie suffisante pour traverser ledit isolant (36) et pénétrer dans ledit conducteur (38).

2. Procédé selon la revendication 1, dans lequel ledit substrat est dopé au niveau de ladite interface à une concentration en agents dopants d'approximativement 8 x 10¹⁷ à 2 x 10¹⁸ atomes/cm³.

3. Procédé selon la revendication 1, dans lequel ledit substrat (30) comporte du silicium cristallin.

4. Procédé selon la revendication 1, dans lequel ledit isolant (36) est du dioxyde de silicium.

5. Procédé selon la revendication 1, dans lequel ledit champ est appliqué audit conducteur (38) par l'intermédiaire d'un couplage capacitif et ledit conducteur (38) est entouré par un matériau isolant.
